# EUROPEAN PATENT SPECIFICATION

(11) **EP 4 533 509 B1**
(45) Date of publication and mention of the grant of the patent: **01.07.2026**
(21) Application number: 23725580.7
(22) Date of filing: 10.05.2023
(51) Int. Cl.: H01J 37/02, H01J 37/14, H01J 37/28

(54) **MULTI-BEAM PARTICLE MICROSCOPE WITH IMPROVED ALIGNMENT AND METHOD FOR ALIGNING THE MULTI-BEAM PARTICLE MICROSCOPE, AND COMPUTER PROGRAM PRODUCT**
MEHRSTRAHL-PARTIKELMIKROSKOP MIT VERBESSERTER AUSRICHTUNG UND VERFAHREN ZUM AUSRICHTEN DES MEHRSTRAHL-PARTIKELMIKROSKOPS SOWIE COMPUTERPROGRAMMPRODUKT
MICROSCOPE À PARTICULES À FAISCEAUX MULTIPLES AVEC ALIGNEMENT AMÉLIORÉ ET PROCÉDÉ D'ALIGNEMENT DE MICROSCOPE À PARTICULES À FAISCEAUX MULTIPLES, ET PRODUIT DE PROGRAMME INFORMATIQUE

(30) Priority: 03.06.2022 DE 102022114098
(43) Date of publication of application: 09.04.2025
(73) Proprietor: Carl Zeiss MultiSEM GmbH, 73447 Oberkochen (DE)
(72) Inventor: JACOBI, Joerg, 89518 Heidenheim (DE); BADER, Jonas, 89520 Heidenheim (DE)
(74) Representative: Tesch-Biedermann, Carmen
(86) International application number: PCT/EP2023/025222
(87) International publication number: WO 2023/232283

(56) References cited:
- US-A- 5 578 821
- US-A1- 2011 174 985
- US-A1- 2015 083 911
- US-A1- 2017 213 688
- US-A1- 2019 355 544

## Description

### Field of the invention

The invention relates to a multi-beam particle microscope with improved alignment, to a method for aligning the multi-beam particle microscope, and to an associated computer program product.

### Prior art

With the continuous development of ever smaller and ever more complex microstructures such as semiconductor components, there is a need to further develop and optimize planar production techniques and inspection systems for producing and inspecting small dimensions of the microstructures. By way of example, the development and production of the semiconductor components requires monitoring of the design of test wafers, and the planar production techniques require process optimization for a reliable production with a high throughput. Moreover, there have been recent demands for an analysis of semiconductor wafers for reverse engineering and for a customer-specific, individual configuration of semiconductor components. Therefore, there is a need for inspection means which can be used with a high throughput for examining the microstructures on wafers with a high accuracy.

Typical silicon wafers used in the production of semiconductor components have diameters of up to 300 mm. Each wafer is divided into 30 to 60 repeating regions ("dies") with a size of up to 800 mm². A semiconductor apparatus comprises a plurality of semiconductor structures, which are produced in layers on a surface of the wafer by planar integration techniques. Semiconductor wafers typically have a plane surface on account of the production processes. The structure size of the integrated semiconductor structures in this case extends from a few µm to the critical dimensions (CD) of 5 nm, with the structure sizes becoming even smaller in the near future; in future, structure sizes or critical dimensions (CD) are expected to be less than 3 nm, for example 2 nm, or even under 1 nm. In the case of the aforementioned small structure sizes, defects in the size of the critical dimensions must be identified quickly in a very large area. For several applications, the specification requirement regarding the accuracy of a measurement provided by inspection equipment is even higher, for example by a factor of two or one order of magnitude. By way of example, a width of a semiconductor feature must be measured with an accuracy of below 1 nm, for example 0.3 nm or even less, and a relative position of semiconductor structures must be determined with an overlay accuracy of below 1 nm, for example 0.3 nm or even less.

The MSEM, a multi-beam scanning electron microscope, is a relatively new development in the field of charged particle systems (charged particle microscopes, CPMs). By way of example, a multi-beam scanning electron microscope is disclosed in US 7 244 949 B2 and in US 2019/0355544 A1. In the case of a multi-beam electron microscope or MSEM, a sample is irradiated simultaneously with a plurality of individual electron beams, which are arranged in a field or grid. By way of example, 4 to 10 000 individual electron beams can be provided as primary radiation, with each individual electron beam being separated from an adjacent individual electron beam by a pitch of 1 to 200 micrometers. By way of example, an MSEM has approximately 100 separate individual electron beams ("beamlets"), which are arranged for example in a hexagonal grid, with the individual electron beams being separated by a pitch of approximately 10 µm. The plurality of charged individual particle beams (primary beams) are focused on a surface of a sample to be examined by way of a common objective lens. By way of example, the sample can be a semiconductor wafer which is secured to a wafer holder mounted on a movable stage. During the illumination of the wafer surface with the charged primary individual particle beams, interaction products, for example secondary electrons or backscattered electrons, emanate from the surface of the wafer. Their start points correspond to those locations on the sample on which the plurality of primary individual particle beams are focused in each case. The amount and the energy of the interaction products depend on the material composition and the topography of the wafer surface. The interaction products form a plurality of secondary individual particle beams (secondary beams), which are collected by the common objective lens and which are incident on a detector arranged in a detection plane as a result of a projection imaging system of the multi-beam inspection system. The detector comprises a plurality of detection regions, each of which comprises a plurality of detection pixels, and the detector captures an intensity distribution for each of the secondary individual particle beams. An image field of, for example, 100 µm × 100 µm is obtained in the process.

The multi-beam electron microscope of the prior art comprises a sequence of electrostatic and magnetic elements. At least some of the electrostatic and magnetic elements are adjustable in order to adapt the focus position and the stigmation of the plurality of charged individual particle beams. The multi-beam system with charged particles of the prior art moreover comprises at least one cross-over plane of the primary or the secondary charged individual particle beams. Moreover, the system of the prior art comprises detection systems to make the adjustment easier. The multi-beam particle microscope of the prior art comprises at least one beam deflector ("deflection scanner") for collective scanning of a region of the sample surface by means of the plurality of primary individual particle beams in order to obtain an image field of the sample surface. Further details regarding a multi-beam electron microscope and a method for operating same are described in the international patent application with the application number WO 2021239380 A1.

An alignment of the multi-beam electron microscope, or more generally of a multi-beam particle microscope, is of great importance for precision applications. One aspect of the alignment is the alignment of magnetic lenses of the system. These magnetic lenses can be in particular so-called global magnetic lenses, where substantially all of the charged particles or all of the charged individual particle beams pass through these global magnetic lenses. These lenses must therefore be aligned particularly accurately. Moreover, the fact is that, on account of the geometric dimensions of such a magnetic lens, the magnetic field generated in the lens cannot be deduced exactly. To put it another way, the magnetic fields of lenses manufactured identically within the scope of the manufacturing accuracy may indeed be measurably different from one another, which is why an individual lens alignment is necessary.

In accordance with the prior art, the magnetic lenses in a multi-beam particle microscope are aligned mechanically, experienced technicians performing the alignment of the magnetic lenses manually. Such an alignment often takes several weeks or even months; it is carried out with simultaneous observation of a multi-beam particle microscope image. Screws on the exterior of the multi-beam particle microscope or the housing thereof are adjusted in order to align the magnetic lenses. The alignment and subsequent fixing of the magnetic lenses are normally carried out during the commissioning of the multi-beam particle microscope in production; afterwards, the alignment normally remains unchanged and is carried out on site at the customer's premises only after module exchange or magnetic lens exchange. In this case, the renewed alignment on site at the customer's premises is more difficult since at the customer's premises the multi-beam particle microscope is often incorporated in a production installation and the associated process chain. Long and expensive outage times in a production installation may therefore occur, which need to be avoided.

US 2013/0299697 A1 discloses a charged particle beam applied apparatus for observing a sample, provided with: a beam-forming section that forms a plurality of charged particle beams on a sample; an energy control unit that controls the incident energy of the plurality of charged particle beams that are irradiated onto the sample; a beam current control unit that controls the beam current of the plurality of charged particle beams that are irradiated onto the sample; and a beam arrangement control unit that controls the arrangement in which the plurality of charged particle beams is irradiated onto the sample. The beam-forming section includes a beam splitting electrode, a lens array upper electrode, a lens array middle electrode, a lens array lower electrode and a movable stage, and functions as the beam current control unit or the beam arrangement control unit through selection, by the movable stage, of a plurality of aperture pattern sets. US 2013/0299697 A1 does not deal with the specific problem of alignment of particle optical components. In particular, an alignment of global magnetic lenses is not addressed.

GB 894 569 A published in 1962 discloses a device for compensating axial astigmatism of electron lenses. It refers to a single beam system and a specific objective lens as an electron lens. Correction coils are movably arranged around the objective lens and outside the vacuum chamber. The objective lens itself is not mechanically aligned.

US 2017/213688 A1 proposes a multi-beam apparatus with a total field of view variable in size, orientation and incident angle. The apparatus provides more flexibility to speed the sample observation and enable more samples observable. More specifically, as a yield management tool to inspect and/or review defects on wafers/masks in semiconductor manufacturing industry, the apparatus provides more possibilities to achieve a high throughput and to detect more kinds of defects.

US 2011/174985 A1 relates to a charged particle based lithography system for projecting an image on a target using a plurality of charged particle beamlets for transferring said image to said target, said system comprising a charged particle column comprising: an electron optical subassembly comprising a charged particle source, a collimator lens, an aperture array, a blanking means and a beamstop for generating a plurality of charged particle beamlets; and a projector for projecting said plurality of charged particle beamlets on said target. The projector is moveably included in the system by means of at least one projector actuator for moving said projector relative to said electron optical subassembly. The projector actuator is included for mechanically actuating said projector and providing said projector with at least one degree of freedom of movement; wherein said degree of freedom relates to a movement around an optical axis of the system.

### Description of the invention

It is therefore the object of the invention to provide an improved multi-beam particle microscope in respect of the alignment of magnetic lenses. The alignment is intended to be able to be carried out in particular more rapidly and if possible also more precisely.

This object is achieved by the subject matter of the independent patent claims. Advantageous embodiments of the invention are evident from the dependent patent claims.

The present patent application claims priority of German patent application No. 10 2022 114 098.9 filed on June 3rd, 2022.

In the case of single-beam particle microscopes, an alignment of magnetic lenses in accordance with the prior art is no longer carried out only mechanically, but rather by means of deflectors that deflect the particle beam such that it is guided through the magnetic lens centre. It therefore appears to be an option in the case of a multi-beam particle microscope, too, to perform the alignment or at least the fine alignment by means of electrical and/or magnetic deflectors. However, following thorough investigations by the inventors, this approach proves to be problematic:
A multi-beam particle microscope typically uses landing energies in the range of approximately 0.3 keV to approximately 5 keV, for which purpose relatively high beam energies of approximately 30 keV are used within the column. On account of these high beam energies, high field strengths are also required in order to be able to deflect the individual particle beams within the column. The use of high deflection field strengths in turn requires high voltages and/or high currents, which entails parasitic effects that adversely affect the beam quality. Therefore, it is surprisingly better to carry out a mechanical alignment in the case of a multi-beam particle microscope.

The present invention therefore proposes an electrically controllable mechanical alignment. This allows a rapid alignment with at the same time improved precision.

Specifically, in accordance with a first aspect, the invention relates to a multi-beam particle microscope for sample inspection, comprising the following:
at least one particle source configured to generate a divergent beam of charged particles;
a condenser lens system, through which the beam of charged particles passes;
a multi-beam generator, which is arranged downstream of the condenser lens system in the direction of the beam path of the particles in such a way that at least some charged particles pass through openings in the multi-beam generator in the form of a plurality of individual particle beams, and which is configured to generate a first field of a multiplicity of charged first particle beams;
a first particle optical unit with a first particle optical beam path, configured to image the generated first individual particle beams onto a sample surface in the object plane such that the first particle beams are incident on the sample surface at incidence locations, which form a second field;
a detection system with a multiplicity of detection regions that form a third field;
a second particle optical unit with a second particle optical beam path, configured to image second individual particle beams, which emanate from the incidence locations in the second field, onto the third field of the detection regions of the detection system;
a magnetic and/or electrostatic objective lens, through which both the first and the second individual particle beams pass;
a beam switch, which is arranged in the first particle optical beam path between the multi-beam generator and the objective lens and which is arranged in the second particle optical beam path between the objective lens and the detection system;
wherein the condenser lens system and/or the first particle optical unit and/or the second particle optical unit comprise(s) at least one alignable magnetic lens arranged in a housing by means of a mount in such a way that charged particles pass through it,
wherein an electrically controllable mechanical alignment and fixing means with an actuator system is furthermore provided for the at least one alignable magnetic lens, said means being configured to mechanically align and mechanically fix a position of the at least one alignable magnetic lens in the particle optical beam path in a plane orthogonal to the optical axis of the multi-beam particle microscope, and
a controller configured to electrically control the electrically controllable mechanical alignment and fixing means.

The charged particles can be e.g. electrons, positrons, muons or ions or other charged particles. Preferably, the charged particles are electrons generated e.g. using a thermal field emission source (TFE). However, other particle sources can also be used.

The individual particle beams are arranged here in a grid arrangement, that is to say an arrangement of the individual particle beams relative to one another is preferably fixed or can be selected. Preferably, this is a regular grid arrangement, which can provide, for example, a square, rectangular or hexagonal arrangement of the individual particle beams relative to one another, in particular with uniform spacing. It is advantageous if the number of individual particle beams is 3 n (n - 1) + 1, where n is any natural number.

The multi-beam particle microscope is preferably a system operating with a single column, but it is also possible for the multi-beam particle microscope to be realized by means of a multi-column system.

The condenser lens system and/or the first particle optical unit and/or the second particle optical unit comprise(s) at least one alignable magnetic lens arranged in a housing by means of a mount in such a way that charged particles pass through it. This alignable magnetic lens can be, in principle, any of the magnetic lenses typically present in the multi-beam particle microscope. It is preferably a global magnetic lens, through which a multiplicity of, and in particular all, individual particle beams pass; however, it is also possible for the alignable magnetic lens to be situated upstream of the multi-beam generator in the particle optical beam path and, instead of as yet individual particle beams, for a diverging beam of charged particles, for example, to pass through said lens. Examples of alignable magnetic lenses are condenser lenses, field lenses and projection lenses. It holds true very generally that an alignable magnetic lens in the context of this patent application is understood to mean a magnetic lens whose position in the particle optical beam path is alterable in a targeted manner in a plane orthogonal to the optical axis of the system. In this case, the aim of the alignment is to guide the beam of charged particles or the multiplicity of individual particle beams parallel to the optical axis through the magnetic lens centre. In this case, generally, the magnetic lens centre does not correspond exactly to the geometric centre of the magnetic lens, which, as described above, firstly necessitates the alignment of magnetic lenses and secondly makes the alignment more difficult, in principle.

The mount of the alignable magnetic lens keeps the latter in its position, in principle, but allows the freedom of movement necessary for the alignment process. A typical mount for a magnetic lens is a so-called clamping ring, for example, which clamps a lens pot of the magnetic lens (the magnetic lens can be subdivided into a lens pot and a lens cover). The mount is suitably connected to a housing in which the alignable magnetic lens is arranged; this housing can be for example an exterior housing of the multi-beam particle microscope.

According to the invention, an electrically controllable mechanical alignment and fixing means with an actuator system is provided for the at least one alignable magnetic lens, said means being configured to mechanically align and mechanically fix a position of the at least one alignable magnetic lens in the particle optical beam path in a plane orthogonal to the optical axis of the system. The aforementioned plane is also referred to hereinafter as alignment plane. The maintaining of a mechanical alignment and fixing avoids the parasitic effects with negative effects on the beam quality that occur in the case of an electrical and/or magnetic deflection. At the same time, the electrical control makes possible advantages in respect of the accuracy and reproducibility of the alignment which are not attainable in the case of a purely manual mechanical alignment. The electrical control makes it possible to achieve an improvement by approximately a factor of 100 in respect of the attainable accuracy in the alignment.

Moreover, a skilful arrangement of the electronically controllable mechanical alignment and fixing means makes it possible to align even such magnetic lenses which were previously not alignable manually: Specifically, not every magnetic lens in a multi-beam particle microscope is actually accessible for alignment through an outer housing without problems. It is immediately evident that if alignment screws and fixing screws are used for the mechanical alignment and fixing, for example, a technician specifically has to get at these screws during a purely manual mechanical alignment, which is typically the case if the screws to be adjusted are arranged near the housing wall of the multi-beam particle microscope, this wall normally being embodied in tubular fashion; for magnetic lenses further inside, a manual alignment in this manual way is not possible.

The electrically controllable mechanical alignment and fixing means with an actuator system according to the invention can be embodied integrally or in multipartite fashion, in principle. It is also possible for the electrically controllable mechanical alignment and fixing means to comprise a multiplicity of electrically controllable mechanical alignment and fixing means; the term "means" thus by definition encompasses both the singular and the plural of "means". In accordance with one preferred embodiment of the invention, the electrically controllable mechanical alignment and fixing means is multipartite and comprises an electrically controllable mechanical alignment means and an electrically controllable mechanical fixing means in the form of two separate structural units. In this case, it holds true once again that these structural units can be embodied integrally or in multipartite fashion, and it is also possible again for an electrically controllable mechanical alignment means to comprise a multiplicity of electrically controllable mechanical alignment means and for an electrically controllable mechanical fixing means to comprise a multiplicity of electrically controllable mechanical fixing means.

However, instead of a functional separation of alignment means, on the one hand, and fixing means, on the other hand, it is also possible, of course, to provide a combination of an electrically controllable mechanical alignment and fixing means with an actuator system. The functional subdivision ultimately depends on the constructional type of implementation of the electrically controllable mechanical alignment and fixing means with an actuator system.

It holds true very generally that an alignment or aligning is understood to mean adjusting the position of the magnetic lens in the alignment plane. In the case of the fixing, on the other hand, the position adjusted by the alignment is fixed. A fixing is thus a restraint and the two terms are used synonymously in the context of this patent application. In this case, the fixing or restraining force is stronger than the prevailing forces and preferably also stronger than the force of the actuator provided. In the context of this patent application, an actuator is defined very generally as a structural unit pertaining to drive technology which converts an electrical signal into a mechanical movement and thus actively intervenes in the controlled process, namely the alignment and/or fixing. According to the invention, the electrical signal or electrical signals is or are generated by a controller, which can be the controller or a module of the controller of the multi-beam particle microscope itself; however, it is also possible, in principle, to provide the controller separately.

In the context of this patent application, the term alignment means implies mounting or guiding of a means for the alignment. In this case, the mounting or guiding can be implemented by way of customary bearings such as, for example, sliding bearings or by way of forced guidance via joints. Examples thereof are a hexapod, parallel kinematics, shear kinematics, flexures, etc. Sliding bearings have the disadvantage that static friction has to be overcome. This makes a manual alignment more difficult because the point at which the static friction is overcome is unforeseeable and abrupt changes in the adjustment may occur. In this respect, a motorized actuator system can lower the threshold of the static friction for example by way of vibrations such as ultrasonic vibrations, for instance.

The actuator system is limited by the associated force, the range and the resolution or accuracy. In principle, actuators that are already known per se can be used for the invention. By way of example, linear or rotary motors and combinations thereof are suitable, in principle. Piezoelements are also known, for example piezo-stacks with low range and high force or piezo-drives with arbitrary range but low force. Gear mechanisms for transformation can likewise be used (for example screws in threads which are driven by a rotary motor; the rotary movement is thus converted into a linear movement). Pneumatic or hydraulic actuators are also known and suitable in principle.

In accordance with one preferred embodiment of the invention, the electrically controllable mechanical alignment means comprises as actuator a stepper motor with gear mechanism. The gear mechanism is used for transformation and a corresponding selection of the gear mechanism makes it possible to attain a high accuracy in the alignment, for example an accuracy of 0.1 µm or better. By contrast, a typically attainable accuracy in the purely manual mechanical alignment is only approximately 10 µm.

Additionally or alternatively, an electrically controllable mechanical fixing means comprises as actuator a combination comprising a stepper motor and a piezoelement. This combination can be used in particular together with a fixing screw as fixing means. In this case, it is possible to use the first actuator with the stepper motor for first fixing of the fixing means such as a fixing screw, for example, and only afterwards is use made of the second actuator in the form of the piezoelement. In this case, the piezoelement can exert the last contact pressure on the fixing means used, such as a fixing screw, for example, and thus allows a better fixing overall.

Very generally, in accordance with one preferred embodiment of the invention, the electrically controllable mechanical fixing means comprises at least one two-stage actuator system for generating a contact pressure for the fixing means. It is also possible to provide for example a three-stage actuator system or a four-stage actuator system, etc. In addition, it is possible to supplement the combination of actuators with a mechanism for increasing and/or releasing the contact force; additionally or alternatively, a pneumatic system can also be provided.

In accordance with one preferred embodiment of the invention, actuators used are electrically load-free during operation of the multi-beam particle microscope, i.e. an actuator used requires no supply current or no supply voltage during operation of the multi-beam particle microscope; however, there still exists a mechanical load on the actuator, of course. In this case, operation should be understood to mean normal operation of the multi-beam particle microscope, i.e. in other words routine operation after alignment and fixing have been concluded. The electrical load-freedom thus avoids possible parasitic effects on account of fields present, and the operation of the multi-beam particle microscope is more energy-saving and more sustainable.

In accordance with one preferred embodiment of the invention, the electrically controllable mechanical alignment means is configured for a Cartesian alignment and comprises two first alignment units arranged orthogonally to one another in order to align the position of the at least one alignable magnetic lens within the plane (alignment plane) orthogonal to the optical axis of the multi-beam particle beam system. In this case, the orthogonal arrangement of the two first alignment units with respect to one another relates to the direction in which alignment is effected by means of each of the two first alignment units. In this case, the two first alignment units can be structurally identical, but they need not be structurally identical. In addition, it is possible for the bearing regions or interaction regions of the two first alignment units with the alignable magnetic lens or the mount thereof to be arranged such that the sections between bearing region and optical axis of the multi-beam particle microscope form a right angle with one another. Owing to the rotational symmetry normally afforded for the magnetic lenses, this enables the best possible attachment points and the most efficient alignment of the alignable magnetic lens in the particle optical beam path.

In accordance with one preferred embodiment of the invention, each of the two first alignment units arranged orthogonally to one another is arranged on the housing and each of the first alignment units comprises a pressure screw which is movable within the plane orthogonal to the optical axis by means of an actuator assigned to it and which is coupled to the at least one magnetic lens by means of the mount of the magnetic lens in order to alter the position thereof. According to the invention, a thrust force that acts on such a pressure screw is typically more than 150 newtons, preferably more than 170 newtons and most preferably more than 180 newtons. In accordance with one preferred embodiment of the invention, the mount of the magnetic lens is embodied as a clamping ring and the pressure screw presses onto this clamping ring from outside.

In accordance with one preferred embodiment of the invention, a counterbearing is in each case provided on the housing at a position diametrically opposite the first alignment unit in relation to the optical axis. Said counterbearing can be embodied as a spring assembly, for example.

In accordance with an alternative embodiment of the invention, an associated second alignment unit, in particular a structurally identical second alignment unit, is in each case provided on the housing at a position diametrically opposite the first alignment unit in relation to the optical axis, wherein the controller is configured to control the mutually associated first and second alignment units oppositely in coordination with one another. The controller thus brings about a change in position by dx, for example, at the first alignment unit and a change in position by correspondingly -dx at the associated second alignment unit. The use of mutually associated first and second alignment units allows a further increase in precision in the alignment, since possible inaccuracies on the part of the counterbearing do not occur or are replaced by an accurately known position of the second alignment unit.

In accordance with one preferred embodiment of the invention, the electrically controllable mechanical fixing means comprises a plurality of separate fixing units, in particular fixing screws, which each act on an element of the mount of the at least one alignable magnetic lens and thereby fix the position of the at least one alignable magnetic lens. It is possible to provide for example two or three or four or even more fixing units. Particular preference is given to providing four separate fixing units, which are provided in a manner alternating with first and second alignment units circumferentially on the outside relative to the alignable magnetic lens, for example. In this example, therefore, a fixing unit is always situated between two alignment units (regardless of whether this is a first or a second alignment unit).

In accordance with one preferred embodiment of the invention, the fixing is effected by means of frictional force or by means of geometric blocking. A fixing by means of frictional force is advantageous for example if the mount of the alignable magnetic lens is not fixedly connected to the lens. By way of example, if a clamping ring is provided as the mount of the magnetic lens, this can only move axially and is not connected to the lens. A fixing of the clamping ring then indirectly fixes the position of the magnetic lens as well, specifically by way of the frictional force resulting from the contact pressure of the fixing means. If the mount or the clamping ring is not fixedly connected to the lens, then this enables a freer movement during the alignment of the magnetic lens.

In accordance with an alternative embodiment of the invention, the mount, and in particular a clamping ring, is fixed to the lens and follows it during the alignment. As a result of fixing screws being fitted, the movement of the lenses is then geometrically blocked, specifically ideally both axially and radially.

In accordance with one preferred example, a fixing direction is both oblique with respect to the optical axis of the multi-beam particle microscope and oblique with respect to the alignment plane. This results in both a radial and an axial fixing of the alignable magnetic lens by means of the mount such as the clamping ring, for example.

In accordance with one preferred embodiment of the invention, the plurality of fixing units are each arranged between alignment units adjacent to one another or between an alignment unit and a counterbearing adjacent to said alignment unit. Adjacent relates to the circumferential direction around the magnetic lens. This enables a very uniform and secure fixing.

In accordance with a further preferred embodiment of the invention, the electrically controllable mechanical alignment and fixing means is not designed in the form of two functionally different separate structural units, but rather as a combined electrically controllable mechanical alignment and fixing means. In contrast to the above-described embodiment variant with functionally separate structural units, this embodiment variant of the invention is not retrofittable in existing systems. In this embodiment variant, for example, the alignable magnetic lens can be coupled to the actuator via a fixed connection such as a flexure, for example, such that said actuator can shift the magnetic lens back and forth. In this way, it is also possible for only exactly one actuator to be required per alignment direction, i.e. for example in the x-direction or in the y-direction; a counterbearing such as a spring assembly is no longer necessary, nor is there any need to provide first and second alignment units opposite one another.

In accordance with one preferred embodiment of the invention, the combined electrically controllable mechanical alignment and fixing means comprises a plurality of structurally identical combined electrically controllable mechanical alignment and fixing means. It is possible, for example, to provide two combined electrically controllable mechanical alignment and fixing means such that a Cartesian alignment can be realized.

In accordance with one preferred embodiment of the invention, the at least one alignable magnetic lens comprises a lens pot and a lens cover, wherein the lens pot and/or the lens cover are/is alignable and fixable independently of one another by means of the electrically controllable mechanical alignment and fixing means. It is possible, for example, to provide per alignable magnetic lens a total of two electrically controllable mechanical alignment and fixing means each with an actuator system, which, as already described above, can be subdivided into a plurality of means and structural units and/or alignment units. The separate aligning of lens pot, on the one hand, and lens cover, on the other hand, affords the advantage that a possible tilt of the alignable magnetic lens can also be corrected as a result. Specifically, if lens pot, on the one hand, and lens cover, on the other hand, are not seated centrally one above the other, then this corresponds to a tilting of the axis of the magnetic field. What is of interest here is that a tilting can be simulated in this way, without a mechanical component part actually having to be tilted for this purpose.

In accordance with a further preferred embodiment of the invention, the at least one alignable magnetic lens is furthermore alignable and fixable in the direction of the optical axis of the system by means of the or by means of a further electrically controllable mechanical alignment and fixing means. In other words, an alignment in the z-direction can also be performed with a corresponding actuator system.

In accordance with a further preferred embodiment of the invention, the multi-beam particle microscope comprises a user interface for the controller. It is thus possible for the control of the electrically controllable mechanical alignment and fixing means to be performed electrically via the user interface. Preferably, the user interface also comprises an image display unit in order to display a particle optical image. The latter may have been recorded with a current alignment adjustment, for example, and may enable a technician to draw conclusions about the status or the progress of the alignment.

In accordance with one preferred embodiment of the invention, the user interface is provided remotely from the multi-beam particle microscope and is set up for remote maintenance of the multi-beam particle microscope. The possibility for remote maintenance is a consequence of the fact that the mechanical alignment need no longer be carried out manually by a technician on site. The fact, too, that a multi-beam particle microscope, at the customer's premises, is often embedded in a process chain or production installation that is difficult to access now no longer poses any problem whatsoever for the alignment of the magnetic lenses. Moreover, it is possible, in principle, to align more magnetic lenses than is possible in the prior art, since the required actuator system and the corresponding lines can be concomitantly integrated in the multi-beam particle microscope from the outset. Accessibility in the vicinity of the housing of the particle beam microscope is not necessarily required any more. In addition, the electrically controllable mechanical alignment and fixing by means of an actuator system affords the further advantage that an alignment can be logged. It is also possible to leave an alignment point and subsequently head for it again precisely, which is precluded in practice by means of a manual alignment. Moreover, it is possible to automate an alignment altogether and to develop alignment algorithms for the alignment in order to rapidly and efficiently realize the best adjustments for the magnetic lenses.

In accordance with a further aspect of the invention, the latter accordingly relates to a method for aligning the multi-beam particle microscope as described above in multiple embodiment variants, the method comprising the following steps:
a) operating the multi-beam particle microscope with a multiplicity of N actuated magnetic lenses, each comprising an electrically controllable mechanical alignment and fixing means with an actuator system, wherein each actuator system allows the movement of one of the N magnetic lenses with one or a plurality of degrees of freedom f. The number of degrees of freedom available in total during the aligning of the actuated magnetic lenses is thus given by the summation of all degrees of freedom f of all the actuated magnetic lenses. Thus, by way of example, if five magnetic lenses each have two actuated degrees of freedom, then this results in a total of 10 degrees of freedom. However, it is also possible for some lenses to have only one degree of freedom, while other magnetic lenses have a plurality of degrees of freedom, for example two, three or even more degrees of freedom, specifically if, on the one hand, the lens pot and, on the other hand, the lens cover are individually alignable.
b) ascertaining a sensitivity of a change in position for each actuated magnetic lens and per degree of freedom of the actuated magnetic lens and ascertaining associated influence vectors on the basis of the ascertained sensitivities.
c) generating a particle optical image by means of the multi-beam particle microscope and ascertaining an image aberration.
d) determining a sum aberration vector for the ascertained image aberration.
e) singular value decomposition of the sum aberration vector with respect to the ascertained influence vectors and, on the basis thereof, ascertaining manipulated variables for each actuated magnetic lens and for each degree of freedom of the actuated magnetic lens, and
f) electrically controlling the mechanical alignment and fixing means of the actuated magnetic lenses by means of the controller in accordance with the ascertained manipulated variables in order to reduce or eliminate the image aberration.

Accordingly, the method according to the invention is based on linear systems theory. It is assumed that individual elements behave linearly and that the behaviour of the overall system is constituted linearly from the individual elements. This assumption of linear systems theory is always valid at least regionally.

In accordance with one preferred embodiment of the invention, the method furthermore comprises the following step:
g) generating a further optical image by means of a multi-beam particle microscope and ascertaining a residual image aberration;
h) iteratively carrying out method steps d) to g) if the residual image aberration is greater than a predetermined upper limit.

This iterative procedure is helpful particularly if, as a result of non-linearities, for example, a sum aberration vector below a threshold cannot immediately be attained.

In accordance with a further preferred embodiment of the invention, the method furthermore comprises the following:
ascertaining influence vectors for various operating points of the multi-beam particle microscope; and/or
storing the influence vectors in a look-up table.

This has the advantage that an alignment of the multi-beam particle microscope becomes possible in a tailored manner for each operating point of the multi-beam particle microscope, which overall increases the resolution and accuracy achievable with the multi-beam particle microscope. In this case, various operating points are understood to mean for example various beam currents, various landing energies, various working distances, etc. It is also possible to include various further ambient parameters of the multi-beam particle microscope in the operating point definition, such as, for example, the ambient temperature around the multi-beam particle microscope. Depending on the choice of the operating point, it is then possible to call up or set the best possible alignment by means of the look-up table.

In accordance with a further embodiment of the invention, the method is carried out in the form of remote maintenance of the multi-beam particle microscope. A systems engineer on site is no longer absolutely necessary at least as far as the alignment itself is concerned, which saves time and costs.

In accordance with a third aspect of the invention, the latter relates to a computer program product having a program code for carrying out the method as described above in a plurality of embodiment variants. In this case, the program code can be programmed in any desired programming language. It is possible for the program code to be subdivided into a plurality of modules. The program code can be executed for example by way of the controller of the multi-beam particle microscope or by way of an associated computer system.

The invention will be understood even better with reference to the accompanying figures, in which:
- Figure 1:: shows a schematic illustration of a multi-beam particle microscope (MSEM);
- Figure 2:: schematically shows aspects of a Cartesian alignment of a magnetic lens;
- Figure 3:: schematically shows an electrically controllable mechanical alignment and fixing of a global magnetic lens in accordance with a first embodiment;
- Figure 4:: schematically shows an electrically controllable mechanical alignment and fixing of a global magnetic lens in accordance with a second embodiment;
- Figure 5:: schematically shows an electrically controllable mechanical alignment and fixing of a global magnetic lens in accordance with a third embodiment;
- Figure 6:: schematically shows an electrically controllable mechanical alignment means comprising a stepper motor with gear mechanism;
- Figure 7:: schematically shows an electrically controllable mechanical fixing means comprising a two-stage actuator system with a stepper motor and a piezoelement;
- Figure 8:: illustrates the functional principle of the two-stage actuator system illustrated in Figure 7; and
- Figure 9:: schematically illustrates a method according to the invention for aligning a multi-beam particle microscope.

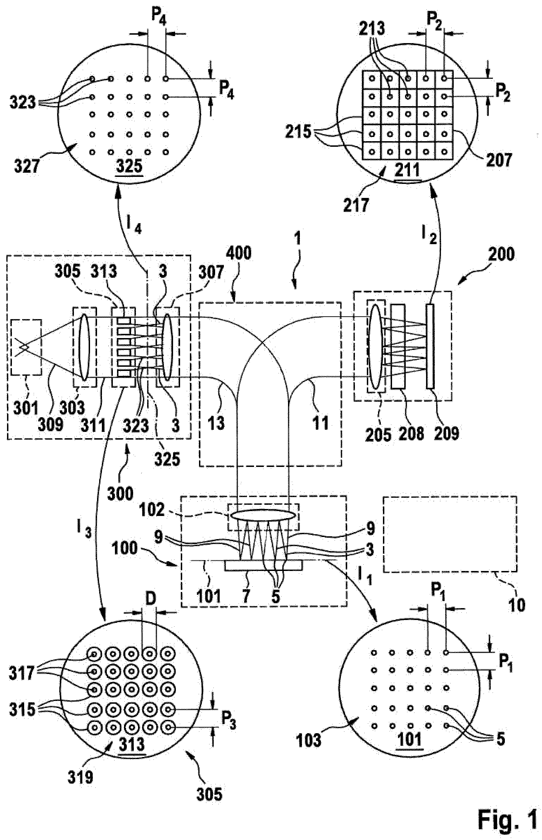

Figure 1 is a schematic illustration of a particle beam system 1 in the form of a multi-beam particle microscope 1, which uses a plurality of particle beams. The particle beam system 1 generates a plurality of particle beams which are incident on an object to be examined in order to generate there interaction products, for example secondary electrons, which emanate from the object and are subsequently detected. The particle beam system 1 is of the scanning electron microscope (SEM) type, which uses a plurality of primary particle beams 3 which are incident on a surface of the object 7 at a plurality of locations 5 and produce there a plurality of electron beam spots, or spots, that are spatially separated from one another. The object 7 to be examined can be of any desired type, e.g. a semiconductor wafer or a biological sample, and can comprise an arrangement of miniaturized elements or the like. The surface of the object 7 is arranged in a first plane 101 (object plane) of an objective lens 102 of an objective lens system 100.

The enlarged detail I1 in Figure 1 shows a plan view of the object plane 101 having a regular rectangular field 103 of incidence locations 5 formed in the first plane 101. In Figure 1, the number of incidence locations is 25, which form a 5 x 5 field 103. The number 25 of incidence locations is a number chosen for reasons of simplified illustration. In practice, the number of beams, and hence the number of incidence locations, can be chosen to be significantly greater, such as, for example, 20 x 30, 100 x 100 and the like.

In the illustrated embodiment, the field 103 of incidence locations 5 is a substantially regular rectangular field having a constant pitch P1 between adjacent incidence locations. Exemplary values of the pitch P1 are 1 micrometre, 10 micrometres and 40 micrometres. However, it is also possible for the field 103 to have other symmetries, such as a hexagonal symmetry, for example.

A diameter of the beam spots shaped in the first plane 101 can be small. Exemplary values of said diameter are 1 nanometre, 5 nanometres, 10 nanometres, 100 nanometres and 200 nanometres. The focusing of the particle beams 3 for shaping the beam spots 5 is carried out by the objective lens system 100.

The primary particles incident on the object generate interaction products, e.g. secondary electrons, backscattered electrons or primary particles which have experienced a reversal of movement for other reasons and which emanate from the surface of the object 7 or from the first plane 101. The interaction products emanating from the surface of the object 7 are shaped by the objective lens 102 to form secondary particle beams 9. The particle beam system 1 provides a particle beam path 11 for guiding the plurality of secondary particle beams 9 to a detector system 200. The detector system 200 comprises a particle optical unit with a projection lens 205 for directing the secondary particle beams 9 at a particle multi-detector 209.

The detail I2 in Figure 1 shows a plan view of the plane 211, in which individual detection regions of the particle multi-detector 209 on which the secondary particle beams 9 are incident at locations 213 are located. The incidence locations 213 lie in a field 217 with a regular pitch P2 with respect to one another. Exemplary values of the pitch P2 are 10 micrometres, 100 micrometres and 200 micrometres.

The primary particle beams 3 are generated in a beam generating apparatus 300 comprising at least one particle source 301 (e.g. an electron source), at least one collimation lens 303, a multi-aperture arrangement 305 and a field lens 307. The particle source 301 generates a diverging particle beam 309, which is collimated or at least substantially collimated by the collimation lens 303 in order to shape a beam 311 which illuminates the multi-aperture arrangement 305.

The detail I3 in Figure 1 shows a plan view of the multi-aperture arrangement 305. The multi-aperture arrangement 305 comprises a multi-aperture plate 313, which has a plurality of openings or apertures 315 formed therein. Midpoints 317 of the openings 315 are arranged in a field 319 that is imaged onto the field 103 formed by the beam spots 5 in the object plane 101. A pitch P3 between the midpoints 317 of the apertures 315 can have exemplary values of 5 micrometres, 100 micrometres and 200 micrometres. The diameters D of the apertures 315 are smaller than the pitch P3 between the midpoints of the apertures. Exemplary values of the diameters D are 0.2 x P3, 0.4 x P3 and 0.8 x P3.

Particles of the illuminating particle beam 311 pass through the apertures 315 and form particle beams 3. Particles of the illuminating beam 311 which are incident on the plate 313 are absorbed by the latter and do not contribute to the formation of the particle beams 3.

On account of an applied electrostatic field, the multi-aperture arrangement 305 focuses each of the particle beams 3 in such a way that beam foci 323 are formed in a plane 325. Alternatively, the beam foci 323 can be virtual. A diameter of the beam foci 323 can be, for example, 10 nanometres, 100 nanometres and 1 micrometre.

The field lens 307 and the objective lens 102 provide a first imaging particle optical unit for imaging the plane 325, in which the beam foci 323 are formed, onto the first plane 101 such that a field 103 of incidence locations 5 or beam spots arises there. If a surface of the object 7 is arranged in the first plane, the beam spots are correspondingly formed on the object surface. The objective lens 102 and the projection lens arrangement 205 provide a second imaging particle optical unit for imaging the first plane 101 onto the detection plane 211. The objective lens 102 is thus a lens that is part of both the first and the second particle optical unit, while the field lens 307 belongs only to the first particle optical unit and the projection lens 205 belongs only to the second particle optical unit.

A beam switch 400 is arranged in the beam path of the first particle optical unit between the multi-aperture arrangement 305 and the objective lens system 100. The beam switch 400 is also part of the second optical unit in the beam path between the objective lens system 100 and the detector system 200.

Further information relating to such multi-beam particle beam systems and components used therein, such as, for instance, particle sources, multi-aperture plate and lenses, can be obtained from the international patent applications WO 2005/ 024881 A2, WO 2007/028595 A2, WO 2007/028596 A1, WO 2011/124352 A1 and WO 2007/060017 A2 and the German patent applications DE 10 2013 016 113 A1 and DE 10 2013 014 976 A1.

The multiple particle beam system 1 furthermore comprises a computer system 10 configured both for controlling the individual particle optical components of the multiple particle beam system and for evaluating and analysing the signals obtained by the multi-detector 209. The computer system 10 can be constructed from a plurality of individual computers or components.

The multi-beam particle microscope 1 in accordance with Figure 1 can comprise the components according to the invention, i.e. in particular one or more alignable magnetic lenses and the electrically controllable mechanical alignment and fixing means. The computer system 10 can include the controller according to the invention, but the controller can also be provided separately.

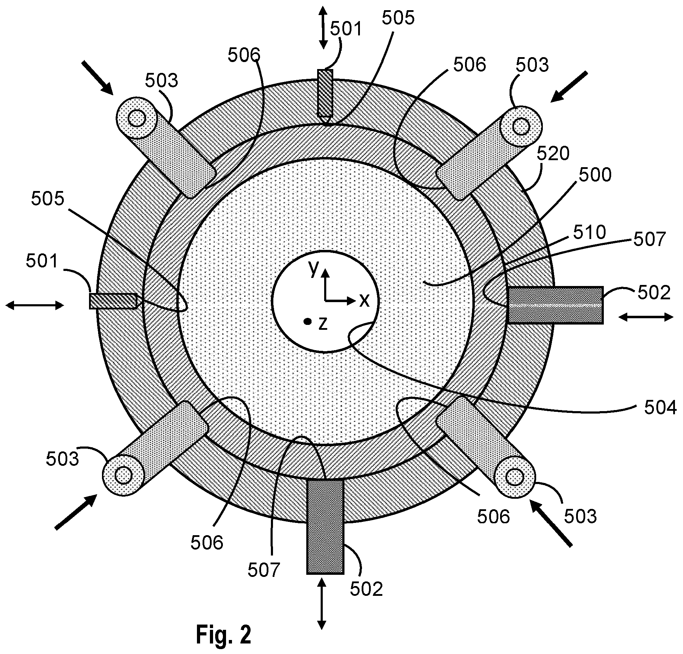

Figure 2 schematically shows aspects of a Cartesian alignment of a magnetic lens 500. The illustration shows a section through the magnetic lens 500, the plane of the drawing corresponding to the alignment plane of the magnetic lens 500. The alignment plane is spanned by the vectors x and y. Oriented perpendicular thereto is the optical axis of the system or of the multi-beam particle microscope 1; the optical axis extends along the z-direction. The section illustrated schematically in Figure 2 extends through the lens pot of the magnetic lens 500. The magnetic lens 500 is held by means of a mount 510, which is embodied in the form of a clamping ring 510 in the present example. The clamping ring holds the magnetic lens 500 in position by means of a clamping and thus by means of frictional force. The clamping ring also has an extent in the z-direction and in this way securely clamps the lens pot of the magnetic lens 500. The magnetic lens 500 together with its mount 510 is arranged in a housing 520. In the example shown, the housing 520 is a tubular portion that can form the outer housing of the multi-beam particle microscope. However, the housing can also be embodied differently or the concrete shape and design of a housing are greatly dependent on that location in the particle optical beam path at which the alignable magnetic lens 500 is actually arranged. In this respect, the illustration in Figure 2 should be understood to be merely by way of example.

When the magnetic lens 500 is aligned correctly, a fanned-out particle beam or the multiplicity of individual particle beams 3 pass(es) through the opening 504 in the magnetic lens 500 centrally, wherein a centre ray or a beam arranged centrally within the field of the multi-beam particle beams is guided through the magnetic lens centre of the magnetic lens 500. In this case, the magnetic lens centre may deviate slightly from the geometric lens centre since it is not possible, on the basis of the geometric and mechanical characteristics of the magnetic lens 500, to predict exactly how the magnetic field generated by the magnetic lens 500 is actually shaped. A precise alignment is therefore needed for precision applications with the multi-beam particle microscope 1.

In the example shown, alignment screws 501 are used for the alignment, said screws pressing onto the clamping ring 510 by way of an attachment point or attachment region 505 for the alignment in the x-direction or respectively y-direction and in this way displacing the magnetic lens 500 held in the clamping ring 510 in the x-direction or respectively y-direction. This displacement capability is indicated in each case by the double-headed arrows in Figure 2. Displacements necessary for the alignment are typically approximately 1 to 2 mm. Larger displacements are normally not required in practice. Arranged diametrically opposite each of the alignment screws 501 is a respective counterbearing 502, embodied in the form of a spring assembly in the example shown. In this way, the entire magnetic lens 500 can follow the movement of the alignment screws 501 within the alignment plane x, y.

In addition to the alignment means 501 illustrated, Figure 2 shows fixing means in the form of fixing screws 503, which each act on the clamping ring 510 and can thereby fix the position of the magnetic lens 500. In the example shown, the fixing direction of the fixing screws 503 is indicated by the single-headed arrows; in this case, the fixing direction is oriented obliquely with respect to the optical axis z and obliquely with respect to the alignment plane (x,y-plane). A corresponding fixing in this oblique direction makes it possible to fix the magnetic lens 500 both in the radial direction and in the axial direction (z-direction).

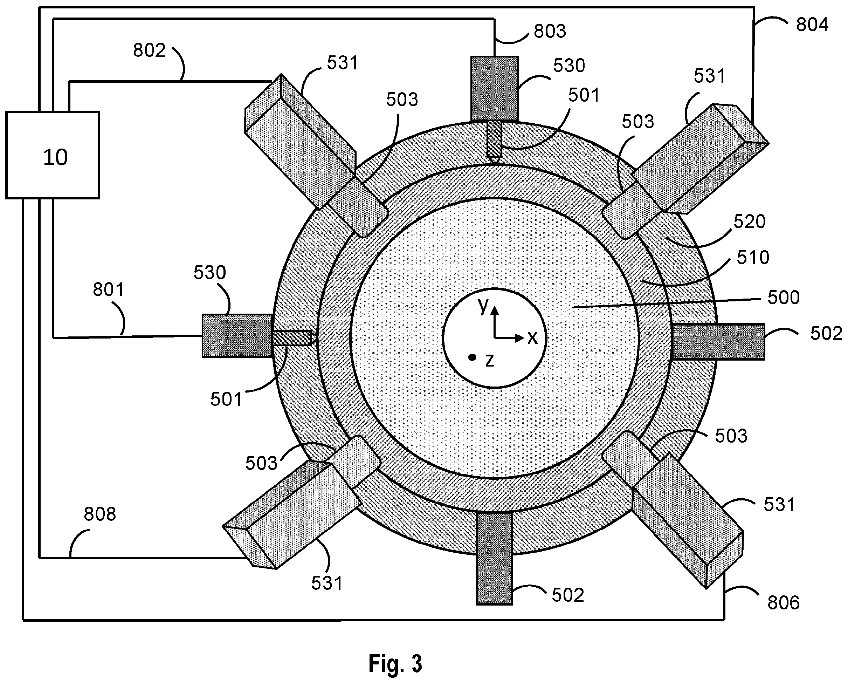

Figure 3 then schematically shows an electrically controllable mechanical alignment and fixing of a global magnetic lens 500 in accordance with a first embodiment. Whereas a mechanical alignment is effected purely manually in Figure 2, Figure 3 shows the electrically controllable mechanical alignment and fixing according to the invention by means of an actuator system. The alignment screws 501 are now no longer operated manually; instead, actuators 530 are provided for the alignment. The controller 10 electrically controls the actuators 530. This allows a very precise and also documentable fine alignment of the alignment screws 501. In a similar manner, the fixing screws 503 are connected or coupled to an actuator 531 for the fixing. These actuators 531, too, are electrically controlled by means of the controller 10. The embodiment variant illustrated in Figure 3 shows a retrofittable embodiment variant, in principle. It is nevertheless pointed out that the embodiment variant illustrated in Figure 3 should be understood to be merely by way of example and in no way restrictive for the invention.

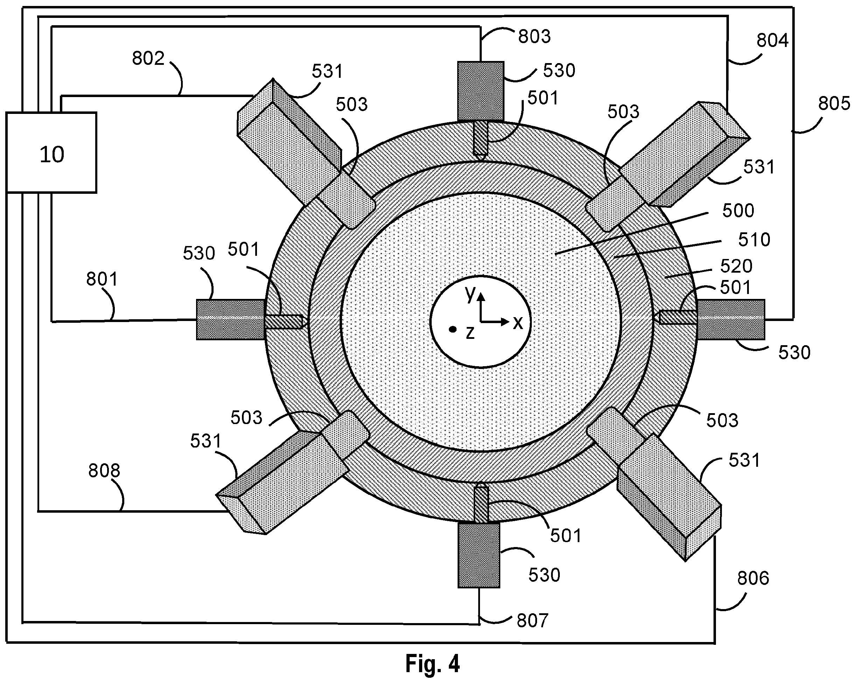

Figure 4 schematically shows an electrically controllable mechanical alignment and fixing of a global magnetic lens 500 in accordance with a second embodiment. Compared with the embodiment variant illustrated in Figure 3, in Figure 4 the counterbearings or spring assemblies 502 are replaced by alignment screws 501 and an actuator system 530 coupled thereto. This has the effect that more signal lines 801 to 808 are admittedly provided. However, the situation now is that the signals from alignment means associated with a specific alignment direction are coupled to one another: The signals of the lines 801 and 805 control, oppositely and in coordination with one another in each case, the mutually associated first and second alignment units 530, 501 which position the magnetic lens 500 in the x-direction. The first and second alignment units 530, 501 assigned to one another can be structurally identical here, but they need not be structurally identical. In an analogous form, the signals of the lines 803 and 807 of the first and second alignment units 530, 501 which align the magnetic lens 500 in the y-direction are coordinated with one another and the control is effected oppositely. After alignment has been carried out, the four fixing units 531, 503 are then controlled by means of the signal lines 802, 804, 806 and 808.

In the embodiment variants illustrated in Figure 3 and Figure 4, the electrically controllable mechanical alignment and fixing means is designed in multipartite fashion and in the form of two separate structural units (one structural unit - which is in turn multipartite - for the alignment and a further structural unit - which is in turn multipartite - for the fixing). However, it is also possible, of course, for the electrically controllable mechanical alignment and fixing means to be embodied as one structural unit. This necessitates equipping the electrically controllable mechanical alignment and fixing means with an actuator system combined in one component, and a restraint, on the other hand. It is then possible to dispense with separate fixing means.

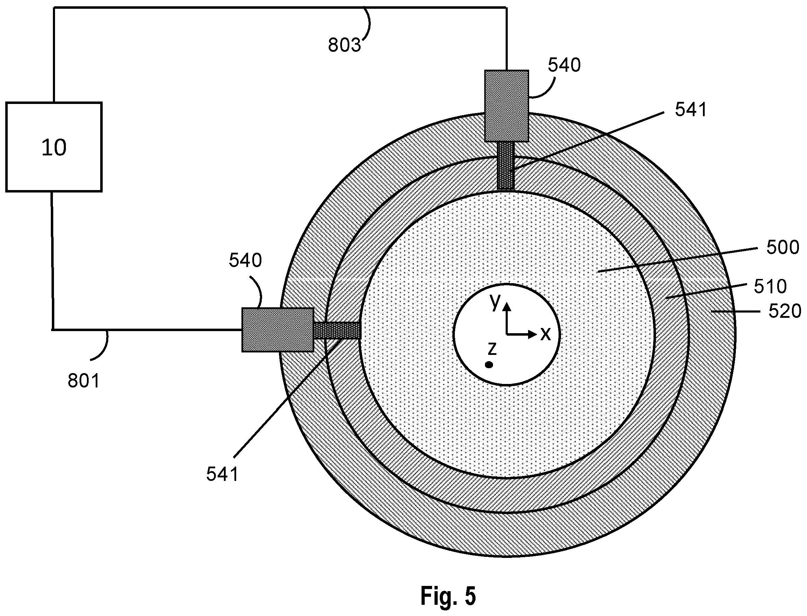

Figure 5 schematically shows an electrically controllable mechanical alignment and fixing of a global magnetic lens 500 in accordance with a third embodiment. In this embodiment, the electrically controllable mechanical alignment and fixing means is provided in a combined structural unit used both for alignment and for fixing. In accordance with the variant shown in Figure 5, this combined alignment and fixing means provides respectively an alignment and fixing means for each alignment direction, that is to say that the combined alignment and fixing means is in turn embodied in multipartite fashion. In the example shown, the magnetic lens 500 is coupled to an actuator 540 by means of a fixed connection such as a flexure 541, for example, such that said actuator 540 can displace the magnetic lens 500 in each case in the positive and negative x-direction or respectively y-direction. As a result, only one actuator 540 in each case is required for an alignment in the x-direction or respectively in the y-direction.

Moreover, it is also possible for the lens pot and lens cover of the magnetic lens 500 to be made alignable separately from one another. If the lens pot and lens cover are not arranged exactly centrally with respect to one another, it is thereby possible to simulate tiltings of the magnetic lens 500 and it is also possible to carry out a correction of a tilt in the particle beam system 1.

Additionally or alternatively, it is also possible to provide further actuating elements in the direction of the optical axis (z-direction), which can compensate for thermal effects, for example. In accordance with a further preferred embodiment of the invention, the at least one alignable magnetic lens 500 is furthermore alignable and fixable in the direction of the optical axis (z-direction) of the system by means of the or by means of a further electrically controllable mechanical alignment and fixing means. In other words, an alignment in the z-direction can also be performed with a corresponding actuator system.

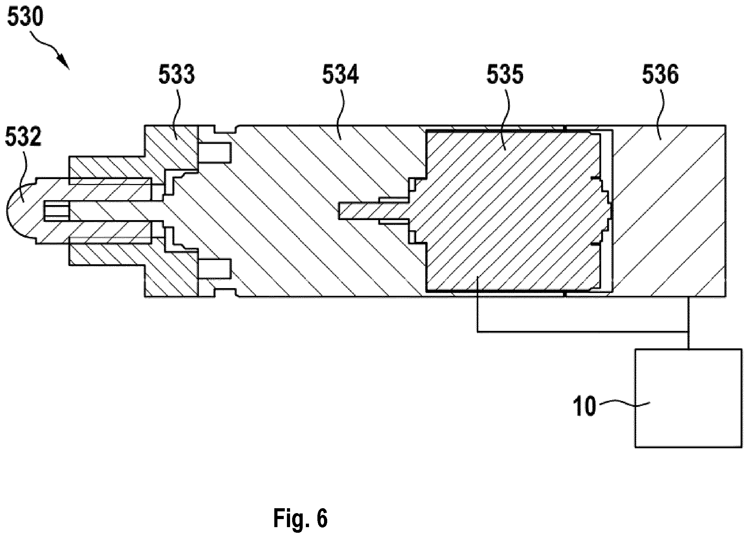

Whereas the actuators 530, 531 and 540 are merely illustrated conceptionally in Figures 3 to 5, Figures 6 and 7 schematically show concrete embodiments for an actuator system for alignment and fixing, respectively. Figure 6 schematically shows an electrically controllable mechanical alignment means 530 comprising a stepper motor 534 with gear mechanism. The motor 535 causes the gear mechanism 534 to effect a rotational movement, and a translational movement of the pressure pin 532 arises in interplay with the pin. A step counter 536 makes the position of the pressure pin 532 determinable and thus allows the alignment to be documented. For this purpose, the motor 535 and the step counter 536 are connected to the controller 10. The actuator 530 for the alignment is directly or indirectly connectable by means of a flange 533 to the magnetic lens 500 (not illustrated) to be aligned; by way of example, the flange 533 can be secured or screwed in at the housing 520 of a multi-beam particle microscope 1. Typical dimensions of the exemplary embodiment illustrated in Figure 6 are a few centimetres in length and less than 2 cm in diameter. The achievable thrust forces are more than 150 N, for example more than 180 N, and an alignment accuracy is 0.01 µm or better.

Figure 6 shows by way of example an embodiment of an actuator system with a linear gear mechanism. However, it is also possible, of course, to use a bevel gear mechanism instead of a linear gear mechanism or in addition to a linear gear mechanism. In this case, the choice of gear mechanism can be adapted to the available structural space/the geometric conditions.

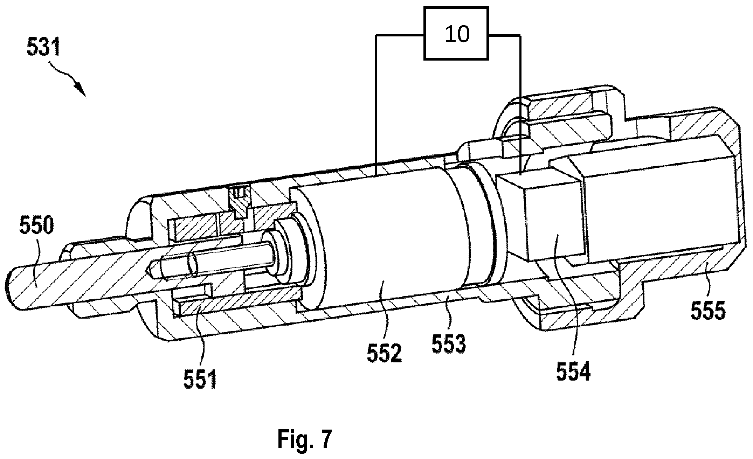

Figure 7 schematically shows an electrically controllable mechanical fixing means 531 comprising a two-stage actuator system with a stepper motor 552 and a piezoelement 554. The two-stage actuator system is arranged in a housing 553, which has a cover 555 in the example shown. A plunger 550 is arranged movably within a bush 551, and can be moved translationally by means of the motor 552. A comparatively large stroke can be realized by way of the motor 552. The piezoactuator 554 has a comparatively small stroke, but as the second stage supplies a further contact pressure by which the plunger 550 as the fixing element presses directly or indirectly on the magnetic lens 500 in order to fix the latter. This two-stage actuator system has proved to be advantageous if the largest possible fixing force or holding force has to be applied to the magnetic lens 500 or an element of the mount 510 thereof. At least in the case of the second stage of the actuator system (piezoactuator 554), no rotations are required during application of the holding force, which enables a greater accuracy and a greater holding pressure/contact pressure.

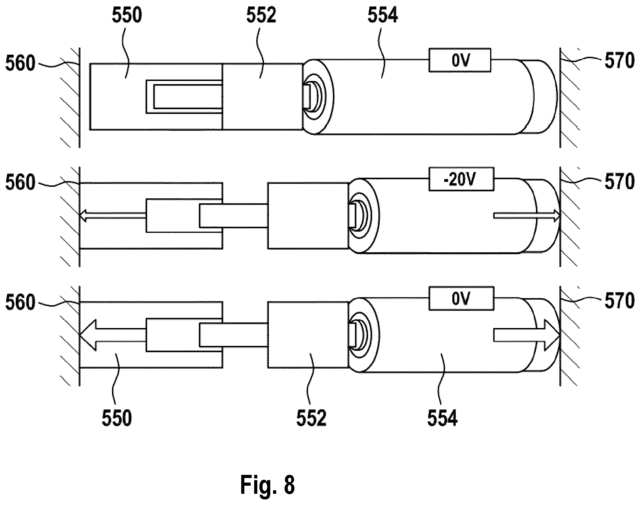

Figure 8 illustrates the functional principle of the two-stage actuator system illustrated in Figure 7: The situation without application of a contact pressure or holding force is illustrated at the top in Figure 8.

A first stage of the actuator system is illustrated in the middle of Figure 8: A negative voltage is applied to the piezoactuator 554 and the piezoactuator 554 therefore contracts or becomes shorter. A mechanical prestress is built up. In addition, the motor 552 with the spindle is controlled and the plunger 550 is driven and moved axially and the entire unit becomes braced between the mount of the magnetic lens 500 and the fixedly arranged piezoactuator 554. The bearing is illustrated merely schematically by the bearing regions 560 and 570 in Figure 8.

In a second stage of the actuator system (cf. illustration at the bottom in Figure 8), the electrical voltage is switched off again and the piezoactuator 554 attempts to become longer. Its mechanical prestress now presses on the motor 552 together with spindle and, mediated thereby, on the plunger 550. In this way, it is possible to build up a high fixing force on the mount 510 of the magnetic lens 500 or on the abovementioned clamping ring 510.

In the case of the embodiments of the actuator system described in greater detail by way of example, it is advantageous that they can be operated in an electrically load-free manner during operation of the multi-beam particle microscope 1. That means that during normal operation of the multi-beam particle microscope 1, no voltage need be present at the actuator, that is to say that no electromagnetic fields that could contribute to parasitic effects are present owing to the actuator system. Moreover, this fact should be assessed positively in the sense of the sustainability of the multi-beam particle microscope 1.

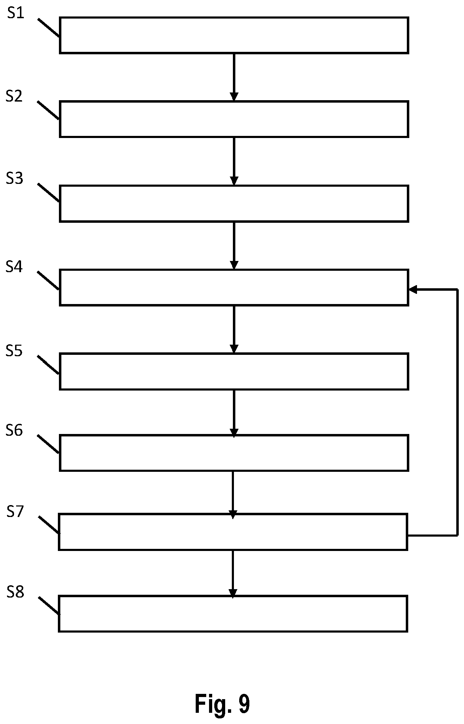

Figure 9 schematically illustrates a method according to the invention for aligning a multi-beam particle microscope 1. The method for aligning the multi-beam particle microscope can be realized by an application of linear systems theory. It is an at least regionally valid statement that individual elements of a system behave linearly and that the behaviour of the overall system is constituted linearly from the individual elements. Against this background, a method for aligning the multi-beam particle microscope 1 can be designed as follows, for example:
A first method step S1 involves operating the multi-beam particle microscope 1 with a multiplicity of N actuated magnetic lenses 500, each comprising an electrically controllable mechanical alignment and fixing means with an actuator system, wherein each actuator system allows the movement of one of the N magnetic lenses 500 with one or a plurality of degrees of freedom f.

A second method step S2 involves ascertaining a sensitivity of a change in position for each actuated magnetic lens 500 and per degree of freedom f of the actuated magnetic lens 500 and ascertaining associated influence vectors on the basis of the ascertained sensitivities.

A further method step S3 involves generating a particle optical image by means of the multi-beam particle microscope 1 and ascertaining an image aberration.

A fourth method step S4 involves determining a sum aberration vector for the ascertained image aberration.

A further method step S5 involves carrying out a singular value decomposition of the sum aberration vector with respect to the ascertained influence vectors and, on the basis thereof, ascertaining manipulated variables for each actuated magnetic lens 500 and for each degree of freedom f of the respectively actuated magnetic lens 500.

A further method step S6 involves electrically controlling the mechanical alignment and fixing means of the actuated magnetic lenses 500 by means of the controller in accordance with the ascertained manipulated variables in order to reduce or eliminate the image aberration.

A further method step S7 involves generating a further particle optical image by means of the multi-beam particle microscope 1 and ascertaining a residual image aberration. If this residual image aberration is less than or equal to a predetermined upper limit, then the method ends with method step S8. Otherwise, method steps S4 to S7 are repeated.

It is possible to ascertain influence vectors for various operating points of the multi-beam particle microscope 1 and/or to store the influence vectors in a look-up table. In this way, an optimum alignment can be achieved for various operating points. It is even the case that this type of alignment of magnetic lenses is actually carried out for the first time for various operating points.

The supervised alignment and its reproducibility and also its electrical control additionally make it possible to carry out the above-described method for aligning the multi-beam particle microscope 1 in the form of remote maintenance. It is therefore not necessary for a technician on site to carry out the aligning. It is additionally possible, without relatively major disturbances even in the case of a multi-beam particle microscope installed in a production installation, to carry out an alignment or, if appropriate, realignment without appreciable disturbance of the overall operation.

The invention enables an automated alignment of a multi-beam particle microscope with high beam energies. In the case of high beam energies of, for example, more than 10 keV, in particular more than 20 keV, and in particular in the case of multi-beam systems, beam deflection by way of electrostatic deflectors, for example, is made more difficult. According to the invention, the alignment is instead carried out by way of a mechanical position alteration of in particular magnetic lenses. In this case, a lateral position alteration is described in the exemplary embodiments. An equivalent position alteration comprises a tilt in at least one direction of a magnetic lens. Generally, a mechanical position alteration also comprises an offset of magnetic lenses in the axial or z-direction. Besides magnetic lenses, the mechanical position of electrostatic elements, too, can be altered.

### List of reference signs

- 1: Multi-beam particle microscope
- 3: Primary particle beams (individual particle beams)
- 5: Beam spots, incidence locations
- 7: Object
- 9: Secondary particle beams (individual particle beams)
- 10: Computer system, controller
- 11: Secondary particle beam path
- 13: Primary particle beam path
- 25: Sample surface, wafer surface
- 100: Objective lens system
- 101: Object plane
- 102: Objective lens
- 103: Field
- 200: Detector system
- 205: Projection lens
- 209: Particle multi-detector
- 211: Detection plane
- 213: Incidence locations
- 215: Detection region
- 217: Field
- 300: Beam generating apparatus
- 301: Particle source
- 303: Collimation lens system; condenser lens system
- 305: Multi-aperture arrangement, multi-beam generator
- 307: Field lens
- 309: Diverging particle beam
- 311: Illuminating particle beam
- 313: Multi-aperture plate
- 315: Openings in the multi-aperture plate
- 317: Midpoints of the openings
- 319: Field
- 323: Beam foci
- 325: Intermediate image plane
- 327: Field
- 400: Beam switch
- 500: Magnetic lens
- 501: Alignment screw with fine thread
- 502: Counterbearing, spring assembly
- 503: Fixing screw
- 504: Opening
- 505: Attachment point or attachment region for alignment
- 506: Attachment point or attachment region for fixing
- 507: Attachment point or attachment region for counterbearing
- 510: Mount, clamping ring
- 520: Housing
- 530: Actuator for alignment
- 531: Actuator for fixing
- 532: Pressure pin
- 533: Flange
- 534: Gear mechanism
- 535: motor
- 536: Step counter
- 540: Actuator for alignment and fixing
- 541: Connection element, e.g. flexure
- 550: Pressure element, e.g. plunger
- 551: Bush
- 552: Motor with spindle
- 553: Housing
- 554: Piezoactuator
- 555: Housing cover
- 560: Bearing region
- 570: Bearing region
- 801: Signal line
- 802: Signal line
- 803: Signal line
- 804: Signal line
- 805: Signal line
- 806: Signal line
- 807: Signal line
- 808: Signal line

## Claims

1. Multi-beam particle microscope (1) for sample inspection, comprising the following:
at least one particle source (301) configured to generate a divergent beam of charged particles (309);
a condenser lens system (303), through which the beam of charged particles passes;
a multi-beam generator (305), which is arranged downstream of the condenser lens system (303) in the direction of the beam path of the particles in such a way that at least some charged particles pass through openings in the multi-beam generator (305) in the form of a plurality of individual particle beams (3), and which is configured to generate a first field (319) of a multiplicity of charged first particle beams (3);
a first particle optical unit with a first particle optical beam path (13), configured to image the generated first individual particle beams (3) onto a sample surface (25) in the object plane (101) such that the first particle beams (3) are incident on the sample surface (25) at incidence locations (5), which form a second field (103);
a detection system (200) with a multiplicity of detection regions (215) that form a third field (217);
a second particle optical unit with a second particle optical beam path (11), configured to image second individual particle beams (9), which emanate from the incidence locations (5) in the second field (103), onto the third field (217) of the detection regions (215) of the detection system (200);
a magnetic and/or electrostatic objective lens (102), through which both the first (3) and the second individual particle beams (9) pass;
a beam switch (400), which is arranged in the first particle optical beam path (13) between the multi-beam generator (305) and the objective lens (102) and which is arranged in the second particle optical beam path (11) between the objective lens (102) and the detection system (200);
wherein the condenser lens system (303) and/or the first particle optical unit and/or the second particle optical unit comprise(s) at least one alignable magnetic lens (500) arranged in a housing (520) by means of a mount (510) in such a way that charged particles pass through it,
**characterized in that** an electrically controllable mechanical alignment and fixing means with an actuator system (530, 531) is furthermore provided for the at least one alignable magnetic lens (500), said means being configured to mechanically align and mechanically fix a position of the at least one alignable magnetic lens (500) in the particle optical beam path (13) in a plane orthogonal to the optical axis of the multi-beam particle microscope (1), and **in that**
a controller (10) is configured to electrically control the electrically controllable mechanical alignment and fixing means.

2. Multi-beam particle microscope (1) according to Claim 1, wherein the electrically controllable mechanical alignment and fixing means is multipartite and comprises an electrically controllable mechanical alignment means and an electrically controllable mechanical fixing means in the form of two separate structural units.

3. Multi-beam particle microscope (1) according to the preceding claim,
wherein the electrically controllable mechanical alignment means comprises as actuator (530) a stepper motor (535) with gear mechanism (534), and/or
wherein the electrically controllable mechanical fixing means comprises as actuator (531) a combination comprising a stepper motor (535) and a piezoelement (554).

4. Multi-beam particle microscope (1) according to either of Claims 2 and 3,
wherein the electrically controllable mechanical fixing means comprises an at least two-stage actuator system (531) for generating a contact pressure for the fixing means.

5. Multi-beam particle microscope (1) according to any of Claims 2 to 4, wherein the electrically controllable mechanical alignment means is configured for a Cartesian alignment and comprises two first alignment units arranged orthogonally to one another in order to align the position of the at least one magnetic lens (500) within the plane orthogonal to the optical axis of the multi-beam particle microscope (1).

6. Multi-beam particle microscope (1) according to the preceding claim, wherein each of the two first alignment units arranged orthogonally to one another is arranged on the housing (520) and comprises a pressure screw (501) which is movable within the plane orthogonal to the optical axis by means of an actuator assigned to it and which is coupled to the at least one magnetic lens (500) by means of the mount (510) of the magnetic lens (500) in order to alter the position thereof.

7. Multi-beam particle microscope (1) according to the preceding claim, wherein a counterbearing (502), in particular a spring assembly (502), is in each case provided on the housing (520) at a position diametrically opposite the first alignment unit in relation to the optical axis, or
wherein an associated second alignment unit, in particular an associated structurally identical second alignment unit, is in each case provided on the housing (520) at a position diametrically opposite the first alignment unit in relation to the optical axis, wherein the controller (10) is configured to control the mutually associated first and second alignment units oppositely in coordination with one another.

8. Multi-beam particle microscope (1) according to any of claims 2 to 7, wherein the electrically controllable mechanical fixing means comprises a plurality of separate fixing units, in particular fixing screws (503), which each act on an element of the mount (510) of the at least one magnetic lens (500) and thereby fix the position of the at least one magnetic lens (500).

9. Multi-beam particle microscope (1) according to the preceding claim, wherein the fixing is effected by means of frictional force or by means of geometric blocking.

10. Multi-beam particle microscope (1) according to the preceding claim, wherein the plurality of fixing units are each arranged between alignment units adjacent to one another or between an alignment unit and a counterbearing (502) adjacent to said alignment unit.

11. Multi-beam particle microscope (1) according to Claim 1, wherein the electrically controllable mechanical alignment and fixing means is not designed in the form of two functionally different separate structural units, but rather as a combined electrically controllable mechanical alignment and fixing means.

12. Multi-beam particle microscope (1) according to the preceding claim, wherein the combined electrically controllable mechanical alignment and fixing means comprises a plurality of, in particular structurally identical, combined electrically controllable mechanical alignment and fixing means.

13. Multi-beam particle microscope (1) according to any of the preceding claims, wherein the at least one magnetic lens (500) comprises a lens pot and a lens cover, wherein the lens pot and/or the lens cover are/is alignable and fixable independently of one another by means of the electrically controllable mechanical alignment and fixing means.

14. Multi-beam particle microscope (1) according to any of the preceding claims, wherein the at least one magnetic lens (500) is furthermore alignable and fixable in the direction of the optical axis of the system by means of the or by means of a further electrically controllable mechanical alignment and fixing means.

15. Multi-beam particle microscope (1) according to any of the preceding claims, wherein the at least one magnetic lens (500) is one of the following lenses: condenser lens (303), field lens (307), projection lens (205).

16. Multi-beam particle microscope (1) according to any of the preceding claims, wherein actuators (530, 531) used are electrically load-free during operation of the multi-beam particle microscope (1).

17. Multi-beam particle microscope (1) according to any of the preceding claims, comprising a user interface for the controller (10), and
wherein the user interface is provided remotely from the multi-beam particle microscope (1) and is set up for remote maintenance of the multi-beam particle microscope (1).

18. Method for aligning the multi-beam particle microscope (1) according to any of the preceding claims, the method comprising the following steps:
a) operating the multi-beam particle microscope (1) with a multiplicity of N actuated magnetic lenses (500), each comprising an electrically controllable mechanical alignment and fixing means with an actuator system (530), wherein each actuator system (530) allows the movement of one of the N magnetic lenses (500) with one or a plurality of degrees of freedom f;
b) ascertaining a sensitivity of a change in position for each actuated magnetic lens (500) and per degree of freedom of the actuated magnetic lens (500) and ascertaining associated influence vectors on the basis of the ascertained sensitivities;
c) generating a particle optical image by means of the multi-beam particle microscope (1) and ascertaining an image aberration;
d) determining a sum aberration vector for the ascertained image aberration;
e) singular value decomposition of the sum aberration vector with respect to the ascertained influence vectors and, on the basis thereof, ascertaining manipulated variables for each actuated magnetic lens (500) and for each degree of freedom of the actuated magnetic lens (500);
f) electrically controlling the mechanical alignment and fixing means of the actuated magnetic lenses (500) by means of the controller (10) in accordance with the ascertained manipulated variables in order to reduce or eliminate the image aberration.

19. Method according to the preceding claim, furthermore comprising:
g) generating a further particle optical image by means of the multi-beam particle microscope (1) and ascertaining a residual image aberration; and
h) iteratively carrying out method steps d) to g) if the residual image aberration is greater than a predetermined upper limit.

20. Method according to either of Claims 18 and 19, furthermore comprising:
ascertaining influence vectors for various operating points of the multi-beam particle microscope (1); and/or
storing the influence vectors in a look-up table.

21. Method according to any of Claims 18 to 20, wherein the method is carried out in the form of remote maintenance of the multi-beam particle microscope (1).

22. Computer program product having a program code for carrying out the method according to any of Claims 18 to 21.

## Patentansprüche

1. Mehrfachstrahlteilchenmikroskop (1) für eine Probenuntersuchung, das Folgendes umfasst:
mindestens eine Teilchenquelle (301), die konfiguriert ist, einen divergenten Strahl geladener Teilchen (309) zu erzeugen;
ein Kondensorlinsensystem (303), durch das der Strahl geladener Teilchen hindurchläuft;
einen Mehrfachstrahlgenerator (305), der dem Kondensorlinsensystem (303) in der Richtung des Strahlwegs der Teilchen derart nachgelagert angeordnet ist, dass zumindest einige geladene Teilchen durch Öffnungen in dem Mehrfachstrahlgenerator (305) in der Form von mehreren individuellen Teilchenstrahlen (3) laufen, und der konfiguriert ist, ein erstes Feld (319) einer Vielzahl erster Strahlen geladener Teilchen (3) zu erzeugen;
eine erste optische Teilcheneinheit mit einem ersten optischen Teilchenstrahlweg (13), die konfiguriert ist, die erzeugten ersten individuellen Teilchenstrahlen (3) auf eine Probenfläche (25) in der Objektebene (101) derart abzubilden, dass die ersten Teilchenstrahlen (3) auf die Probenfläche (25) an Einfallsorten (5) einfallen, die ein zweites Feld (103) bilden;
ein Detektionssystem (200) mit einer Vielzahl von Detektionsbereichen (215), die ein drittes Feld (217) bilden;
eine zweite optische Teilcheneinheit mit einem zweiten optischen Teilchenstrahlweg (11), die konfiguriert ist, zweite individuelle Teilchenstrahlen (9), die von den Einfallsorten (5) in dem zweiten Feld (103) ausgehen, auf das dritte Feld (217) der Detektionsbereiche (215) des Detektionssystems (200) abzubilden;
eine magnetische und/oder elektrostatische Objektivlinse (102), durch die sowohl der erste (3) als auch der zweite individuelle Teilchenstrahl (9) hindurchlaufen;
einen Strahlschalter (400), der in dem ersten optischen Teilchenstrahlweg (13) zwischen dem Mehrfachstrahlgenerator (305) und der Objektivlinse (102) angeordnet ist und in dem zweiten optischen Teilchenstrahlweg (11) zwischen der Objektivlinse (102) und dem Detektionssystem (200) angeordnet ist;
wobei das Kondensorlinsensystem (303) und/oder die erste optische Teilcheneinheit und/oder die zweite optische Teilcheneinheit mindestens eine ausrichtbare magnetische Linse (500), die in einem Gehäuse (520) mit Hilfe einer Befestigung (510) derart angebracht ist, das geladene Teilchen durch sie hindurchlaufen, umfassen,
**dadurch gekennzeichnet, dass** ferner elektrisch steuerbare mechanische Ausrichtungs- und Befestigungsmittel mit einem Betätigungssystem (530, 531) für die mindestens eine ausrichtbare magnetische Linse (500) bereitgestellt sind, wobei die Mittel konfiguriert sind, eine Position der mindestens einen ausrichtbaren magnetischen Linse (500) in dem optischen Teilchenstrahlweg (13) in einer Ebene senkrecht zu der optischen Achse des Mehrfachstrahlteilchenmikroskops (1) mechanisch auszurichten und mechanisch zu fixieren, und dadurch, dass
eine Steuereinheit (10) konfiguriert ist, die elektrisch steuerbaren mechanischen Ausrichtungs- und Befestigungsmittel elektrisch zu steuern.

2. Mehrfachstrahlteilchenmikroskop (1) nach Anspruch 1, wobei die elektrisch steuerbaren mechanischen Ausrichtungs- und Befestigungsmittel mehrteilig sind und elektrisch steuerbare mechanische Ausrichtungsmittel und elektrisch steuerbare mechanische Befestigungsmittel in der Form von zwei getrennten strukturellen Einheiten umfassen.

3. Mehrfachstrahlteilchenmikroskop (1) nach dem vorhergehenden Anspruch,
wobei die elektrisch steuerbaren mechanischen Ausrichtungsmittel als Betätigungselement (530) einen Schrittmotor (535) mit einem Zahnradmechanismus (534) umfassen und/oder
wobei die elektrisch steuerbaren mechanischen Befestigungsmittel als Betätigungselement (531) eine Kombination umfassen, die einen Schrittmotor (535) und ein Piezoelement (554) umfasst.

4. Mehrfachstrahlteilchenmikroskop (1) nach einem der Ansprüche 2 und 3,
wobei die elektrisch steuerbaren mechanischen Befestigungsmittel ein mindestens zweistufiges Betätigungssystem (531) zum Erzeugen eines Kontaktdrucks für die Befestigungsmittel umfassen.

5. Mehrfachstrahlteilchenmikroskop (1) nach einem der Ansprüche 2 bis 4, wobei die elektrisch steuerbaren mechanischen Ausrichtungsmittel für eine kartesische Ausrichtung konfiguriert sind und zwei erste Ausrichtungseinheiten umfassen, die senkrecht zueinander in der Reihenfolge angeordnet sind, um die Position der mindestens einen magnetischen Linse (500) in der Ebene senkrecht zu der optischen Achse des Mehrfachstrahlteilchenmikroskops (1) auszurichten.

6. Mehrfachstrahlteilchenmikroskop (1) nach dem vorhergehenden Anspruch, wobei jede der zwei ersten Ausrichtungseinheiten, die senkrecht zueinander angeordnet sind, auf dem Gehäuse (520) angeordnet ist und eine Druckschraube (501) umfasst, die innerhalb der Ebene senkrecht zu der optischen Achse mit Hilfe eines Betätigungselements, das ihr zugewiesen ist, beweglich ist, und die an die mindestens eine magnetische Linse (500) mit Hilfe der Befestigung (510) der magnetischen Linse (500) gekoppelt ist, um die Position von ihr zu ändern.

7. Mehrfachstrahlteilchenmikroskop (1) nach dem vorhergehenden Anspruch, wobei in jedem Fall ein Gegenlager (502), insbesondere eine Federanordnung (502), auf dem Gehäuse (520) an einer Position diametral gegenüber der ersten Ausrichtungseinheit in Bezug auf die optische Achse bereitgestellt ist oder
wobei in jedem Fall eine zugeordnete zweite Ausrichtungseinheit, insbesondere eine zugeordnete strukturell identische zweite Ausrichtungseinheit, auf dem Gehäuse (520) an einer Position diametral gegenüber der ersten Ausrichtungseinheit in Bezug auf die optische Achse bereitgestellt ist, wobei die Steuereinheit (10) konfiguriert ist, die gegenseitig zugeordneten gegenüberliegenden ersten und zweiten Ausrichtungseinheiten in Zusammenarbeit miteinander zu steuern.

8. Mehrfachstrahlteilchenmikroskop (1) nach einem der Ansprüche 2 bis 7, wobei die elektrisch steuerbaren mechanischen Befestigungsmittel mehrere getrennte Befestigungseinheiten, insbesondere Befestigungsschrauben (503), die jeweils auf ein Element der Befestigung (510) der mindestens einen magnetischen Linse (500) wirken und dadurch die Position der mindestens einen magnetischen Linse (500) fixieren, umfassen.

9. Mehrfachstrahlteilchenmikroskop (1) nach dem vorhergehenden Anspruch, wobei die Befestigung mit Hilfe einer Reibungskraft oder mit Hilfe einer geometrischen Blockierung bewirkt wird.

10. Mehrfachstrahlteilchenmikroskop (1) nach dem vorhergehenden Anspruch, wobei die mehreren Befestigungseinheiten zwischen Ausrichtungseinheiten, die zueinander benachbart sind, oder zwischen einer Ausrichtungseinheit und einem Gegenlager (502), das zu der Ausrichtungseinheit benachbart ist, angeordnet sind.

11. Mehrfachstrahlteilchenmikroskop (1) nach Anspruch 1, wobei die elektrisch steuerbaren mechanischen Ausrichtungs- und Befestigungsmittel nicht in der Form von zwei funktional verschiedenen getrennten strukturellen Einheiten, sondern eher als vereinigte elektrisch steuerbare mechanische Ausrichtungs- und Befestigungsmittel gestaltet sind.

12. Mehrfachstrahlteilchenmikroskop (1) nach dem vorhergehenden Anspruch, wobei die vereinigten elektrisch steuerbaren mechanischen Ausrichtungs- und Befestigungsmittel mehrere, insbesondere strukturell identische, vereinigte elektrisch steuerbare mechanische Ausrichtungs- und Befestigungsmittel umfassen.

13. Mehrfachstrahlteilchenmikroskop (1) nach einem der vorhergehenden Ansprüche, wobei die mindestens eine magnetische Linse (500) ein Linsengefäß und eine Linsenabdeckung umfasst, wobei das Linsengefäß und/oder die Linsenabdeckung unabhängig voneinander mit Hilfe der elektrisch steuerbaren mechanischen Ausrichtungs- und Befestigungsmittel ausrichtbar und fixierbar sind.

14. Mehrfachstrahlteilchenmikroskop (1) nach einem der vorhergehenden Ansprüche, wobei die mindestens eine magnetische Linse (500) darüber hinaus in der Richtung der optischen Achse des Systems mit Hilfe der oder mit Hilfe weiterer elektrisch steuerbarer mechanischer Ausrichtungs- und Befestigungsmittel ausrichtbar und fixierbar ist.

15. Mehrfachstrahlteilchenmikroskop (1) nach einem der vorhergehenden Ansprüche, wobei die mindestens eine magnetische Linse (500) eine der folgenden Linsen ist: eine Kondensorlinse (303), eine Feldlinse (307), eine Projektionslinse (205).

16. Mehrfachstrahlteilchenmikroskop (1) nach einem der vorhergehenden Ansprüche, wobei Betätigungselemente (530, 531), die verwendet werden, während des Betriebs des Mehrfachstrahlteilchenmikroskops (1) elektrisch ladungsfrei sind.

17. Mehrfachstrahlteilchenmikroskop (1) nach einem der vorhergehenden Ansprüche, das eine Anwenderschnittstelle für die Steuereinheit (10) umfasst, und
wobei die Anwenderschnittstelle entfernt von dem Mehrfachstrahlteilchenmikroskop (1) bereitgestellt ist und für eine entfernte Wartung des Mehrfachstrahlteilchenmikroskops (1) ausgelegt ist.

18. Verfahren zum Ausrichten des Mehrfachstrahlteilchenmikroskops (1) nach einem der vorhergehenden Ansprüche, wobei das Verfahren die folgenden Schritte umfasst:
a) Betreiben des Mehrfachstrahlteilchenmikroskops (1) mit einer Vielzahl von N betätigten magnetischen Linsen (500), die jeweils elektrisch steuerbare mechanische Ausrichtungs- und Befestigungsmittel mit einem Betätigungssystem (530) umfassen, wobei jedes Betätigungssystem (530) die Bewegung einer der N magnetischen Linsen (500) mit einem oder mehreren Freiheitsgraden f erlaubt;
b) Sicherstellen einer Empfindlichkeit einer Positionsänderung für jede betätigte magnetische Linse (500) und pro Freiheitsgrad der betätigten magnetischen Linse (500) und Sicherstellen von zugeordneten Einflussvektoren anhand der sichergestellten Empfindlichkeiten;
c) Erzeugen eines optischen Teilchenbildes mit Hilfe des Mehrfachstrahlteilchenmikroskops (1) und Sicherstellen eines Bildabbildungsfehlers;
d) Bestimmen eines Summenabbildungsfehlervektors für den sichergestellten Bildabbildungsfehler;
e) Eigenwertzerlegung des Summenabbildungsfehlervektors in Bezug auf die sichergestellten Einflussvektoren und anhand dessen Sicherstellen beeinflusster Variablen für jede betätigte magnetische Linse (500) und für jeden Freiheitsgrad der betätigten magnetischen Linse (500);
f) elektrisch Steuern der mechanischen Ausrichtungs- und Befestigungsmittel der betätigten magnetischen Linsen (500) mit Hilfe der Steuereinheit (10) in Übereinstimmung mit den sichergestellten beeinflussten Variablen, um den Bildabbildungsfehler zu verringern oder zu beseitigen.

19. Verfahren nach dem vorhergehenden Anspruch, das ferner Folgendes umfasst:
g) Erzeugen eines weiteren optischen Teilchenbildes mit Hilfe des Mehrfachstrahlteilchenmikroskops (1) und Sicherstellen eines Restbildabbildungsfehlers; und
h) iterativ Ausführen der Verfahrensschritte d) bis g), wenn der Restbildabbildungsfehler größer als eine vorgegebene obere Grenze ist.

20. Verfahren nach einem der Ansprüche 18 und 19, das darüber hinaus Folgendes umfasst:
Sicherstellen von Einflussvektoren für verschiedene Betriebspunkte des Mehrfachstrahlteilchenmikroskops (1); und/oder
Speichern der Einflussvektoren in einer Nachschlagetabelle.

21. Verfahren nach einem der Ansprüche 18 bis 20, wobei das Verfahren in der Form einer entfernten Wartung des Mehrfachstrahlteilchenmikroskops (1) ausgeführt wird.

22. Computerprogrammprodukt mit einem Programmcode zum Ausführen des Verfahrens nach einem der Ansprüche 18 bis 21.

## Revendications

1. Microscope à particules à faisceaux multiples (1) pour inspection d'échantillon, comprenant ce qui suit :
au moins une source de particules (301) configurées pour générer un faisceau divergent de particules chargées (309) ;
un système de lentilles condensatrices (303), à travers lequel passe le faisceau de particules chargées ;
un générateur de faisceaux multiples (305), qui est agencé en aval du système de lentilles condensatrices (303) dans la direction du chemin de faisceau des particules, de manière telle qu'au moins certaines particules chargées passent à travers des ouvertures dans le générateur de faisceaux multiples (305) sous la forme d'une pluralité de faisceaux de particules individuels (3), et qui est configuré pour générer un premier champ (319) d'une multiplicité de premiers faisceaux de particules chargées (3) ;
une première unité optique à particules avec un premier chemin de faisceau optique de particules (13), configurée pour imager les premiers faisceaux de particules individuels générés (3) sur une surface d'échantillon (25) dans le plan d'objet (101), de manière telle que les premiers faisceaux de particules (3) soient incidents sur la surface d'échantillon (25) à des emplacements d'incidence (5), qui forment un deuxième champ (103) ;
un système de détection (200) avec une multiplicité de régions de détection (215) qui forment un troisième champ (217) ;
une seconde unité optique à particules avec un second chemin de faisceau optique de particules (11), configuré pour imager des seconds faisceaux de particules individuels (9), qui émanent des emplacements d'incidence (5) dans le deuxième champ (103), sur le troisième champ (217) des régions de détection (215) du système de détection (200) ;
une lentille d'objectif magnétique et/ou électrostatique (102), à travers laquelle passent le premier (3) et le second faisceaux de particules individuels (9) ;
un commutateur de faisceau (400), qui est agencé dans le premier chemin de faisceau optique de particules (13) entre le générateur de faisceaux multiples (305) et la lentille d'objectif (102) et qui est agencé dans le second chemin de faisceau optique de particules (11) entre la lentille d'objectif (102) et le système de détection (200) ;
dans lequel le système de lentilles condensatrices (303) et/ou la première unité optique à particules et/ou la seconde unité optique à particules comprend (comprennent) au moins une lentille magnétique alignable (500) agencée dans un logement (520) à l'aide d'un support (510), de manière telle que des particules chargées passent à travers celle-ci,
**caractérisé en ce qu'**un moyen commandable électriquement d'alignement et de fixation mécaniques avec un système actionneur (530, 531) est en outre prévu pour l'au moins une lentille magnétique alignable (500), ledit moyen étant configuré pour aligner mécaniquement et fixer mécaniquement une position de l'au moins une lentille magnétique alignable (500) dans le chemin de faisceau optique de particules (13) dans un plan orthogonal à l'axe optique du microscope à particules à faisceaux multiples (1), et **en ce que**
un appareil de commande (10) est configuré pour commander électriquement le moyen commandable électriquement d'alignement et de fixation mécaniques.

2. Microscope à particules à faisceaux multiples (1) selon la revendication 1, dans lequel le moyen commandable électriquement d'alignement et de fixation mécaniques est à parties multiples et comprend un moyen commandable électriquement d'alignement mécanique et un moyen commandable électriquement de fixation mécanique sous la forme de deux unités structurales distinctes.

3. Microscope à particules à faisceaux multiples (1) selon la revendication précédente,
dans lequel le moyen commandable électriquement d'alignement mécanique comprend, en tant qu'actionneur (530), un moteur pas à pas (535) avec un mécanisme d'engrenage (534), et/ou
dans lequel le moyen commandable électriquement de fixation mécanique comprend, en tant qu'actionneur (531), une combinaison comprenant un moteur pas à pas (535) et un piézo-élément (554).

4. Microscope à particules à faisceaux multiples (1) selon l'une ou l'autre des revendications 2 et 3,
dans lequel le moyen commandable électriquement de fixation mécanique comprend un système actionneur au moins à deux étages (531) pour générer une pression de contact pour le moyen de fixation.

5. Microscope à particules à faisceaux multiples (1) selon de quelconques des revendications 2 à 4, dans lequel le moyen commandable électriquement d'alignement mécanique est configuré pour un alignement cartésien et comprend deux premières unités d'alignement agencées orthogonalement l'une à l'autre afin d'aligner la position de l'au moins une lentille magnétique (500) dans les limites du plan orthogonal à l'axe optique du microscope à particules à faisceaux multiples (1).

6. Microscope à particules à faisceaux multiples (1) selon la revendication précédente, dans lequel chacune des deux premières unités d'alignement agencées orthogonalement l'une à l'autre est agencée sur le logement (520) et comprend une vis de pression (501) qui est mobile dans les limites du plan orthogonal à l'axe optique à l'aide d'un actionneur attribué à celle-ci et qui est couplée à l'au moins une lentille magnétique (500) à l'aide du support (510) de la lentille magnétique (500) afin de modifier la position de celle-ci.

7. Microscope à particules à faisceaux multiples (1) selon la revendication précédente, dans lequel un contre-appui (502), en particulier un ensemble ressort (502), est, dans chaque cas, prévu sur le logement (520) à une position diamétralement opposée à la première unité d'alignement relativement à l'axe optique, ou
dans lequel une seconde unité d'alignement associée, en particulier une seconde unité d'alignement structuralement identique associée, est, dans chaque cas, prévue sur le logement (520) à une position diamétralement opposée à la première unité d'alignement relativement à l'axe optique, dans lequel l'appareil de commande (10) est configuré pour commander les première et seconde unités d'alignement mutuellement associées de façon opposée en coordination l'une avec l'autre.

8. Microscope à particules à faisceaux multiples (1) selon quelconques des revendications 2 à 7, dans lequel le moyen commandable électriquement de fixation mécanique comprend une pluralité d'unités de fixation distinctes, en particulier des vis de fixation (503), qui agissent chacune sur un élément du support (510) de l'au moins une lentille magnétique (500) et ainsi fixent la position de l'au moins un lentille magnétique (500).

9. Microscope à particules à faisceaux multiples (1) selon la revendication précédente, dans lequel la fixation est effectuée à l'aide de force de frottement ou à l'aide de blocage géométrique.

10. Microscope à particules à faisceaux multiples (1) selon la revendication précédente, dans lequel la pluralité d'unités de fixation sont chacune agencées entre des unités d'alignement adjacentes les unes aux autres ou entre une unité d'alignement et un contre-appui (502) adjacent à ladite unité d'alignement.

11. Microscope à particules à faisceaux multiples (1) selon la revendication 1, dans lequel le moyen commandable électriquement d'alignement et de fixation mécaniques n'est pas désigné sous la forme de deux unités structurales distinctes fonctionnellement différentes, mais plutôt en tant que moyen combiné commandable électriquement d'alignement et de fixation mécaniques.

12. Microscope à particules à faisceaux multiples (1) selon la revendication précédente, dans lequel le moyen combiné commandable électriquement d'alignement et de fixation mécaniques comprend une pluralité de moyens combinés commandables électriquement d'alignement et de fixation mécaniques, en particulier structuralement identiques.

13. Microscope à particules à faisceaux multiples (1) selon de quelconques des revendications précédentes, dans lequel l'au moins une lentille magnétique (500) comprend un pot de lentille et un couvercle de lentille, dans lequel le pot de lentille et/ou le couvercle de lentille sont/est alignables et fixables indépendamment l'un de l'autre à l'aide du moyen commandable électriquement d'alignement et de fixation mécaniques.

14. Microscope à particules à faisceaux multiples (1) selon de quelconques des revendications précédentes, dans lequel l'au moins une lentille magnétique (500) est en outre alignable et fixable dans la direction de l'axe optique du système à l'aide du moyen, ou à l'aide d'un moyen supplémentaire, commandable électriquement d'alignement et de fixation mécaniques.

15. Microscope à particules à faisceaux multiples (1) selon de quelconques des revendications précédentes, dans lequel l'au moins une lentille magnétique (500) est une des lentilles suivantes : lentille condensatrice (303), lentille de champ (307), lentille de projection (205).

16. Microscope à particules à faisceaux multiples (1) selon de quelconques des revendications précédentes, dans lequel des actionneurs (530, 531) utilisés sont électriquement sans charge durant le fonctionnement du microscope à particules à faisceaux multiples (1).

17. Microscope à particules à faisceaux multiples (1) selon de quelconques des revendications précédentes, comprenant une interface utilisateur pour l'appareil de commande (10), et
dans lequel l'interface utilisateur est prévue à distance du microscope à particules à faisceaux multiples (1) et est installée pour la maintenance à distance du microscope à particules à faisceaux multiples (1).

18. Procédé pour aligner le microscope à particules à faisceaux multiples (1) selon de quelconques des revendications précédentes, le procédé comprenant les étapes suivantes :
a) la mise en fonctionnement du microscope à particules à faisceaux multiples (1) avec une multiplicité de N lentilles magnétiques actionnées (500), chacune comprenant un moyen commandable électriquement d'alignement et de fixation mécaniques avec un système actionneur (530), dans lequel chaque système actionneur (530) permet le mouvement d'une des N lentilles magnétiques (500) avec un ou une pluralité de degrés de liberté f ;
b) la vérification d'une sensibilité d'un changement de position pour chaque lentille magnétique actionnée (500) et pour chaque degré de liberté de la lentille magnétique actionnée (500) et la vérification de vecteurs d'influence associés, sur la base des sensibilités vérifiées ;
c) la génération d'une image optique de particules à l'aide du microscope à particules à faisceaux multiples (1) et la vérification d'une aberration d' image ;
d) la détermination d'un vecteur d'aberration somme pour l'aberration d'image vérifiée ;
e) la décomposition en valeurs singulières du vecteur d'aberration somme par rapport aux vecteurs d'influence vérifiés et, sur la base de celle-ci, la vérification de variables manipulées pour chaque lentille magnétique actionnée (500) et pour chaque degré de liberté de la lentille magnétique actionnée (500) ;
f) la commande électrique du moyen d'alignement et de fixation mécaniques des lentilles magnétiques actionnées (500) à l'aide de l'appareil de commande (10) conformément aux variables manipulées vérifiées, afin de réduire ou d'éliminer l'aberration d'image.

19. Procédé selon la revendication précédente, comprenant en outre :
g) la génération d'une image optique supplémentaire de particules à l'aide du microscope à particules à faisceaux multiples (1) et la vérification d'une aberration d'image résiduelle ; et
h) l'exécution itérative des étapes de procédé d) à g) si l'aberration d'image résiduelle est plus grande qu'une limite supérieure prédéterminée.

20. Procédé selon l'une ou l'autre des revendications 18 et 19, comprenant en outre :
la vérification de vecteurs d'influence pour divers points de fonctionnement du microscope à particules à faisceaux multiples (1) ; et/ou
le stockage des vecteurs d'influence dans une table de consultation.

21. Procédé selon de quelconques des revendications 18 à 20, dans lequel le procédé est exécuté sous la forme de maintenance à distance du microscope à particules à faisceaux multiples (1).

22. Produit programme d'ordinateur ayant un code de programme pour exécuter le procédé selon de quelconques des revendications 18 à 21.
